# EUROPÄISCHE PATENTSCHRIFT

(11) **EP 1 937 866 B1**
(45) Veröffentlichungstag und Bekanntmachung des Hinweises auf die Patenterteilung: **15.12.2010**
(21) Anmeldenummer: 06790256.9
(22) Anmeldetag: 05.10.2006
(51) Int. Cl.: C23C 14/34

(54) **ROHRTARGET**
TUBE TARGET
CIBLE TUBULAIRE

(30) Priorität: 14.10.2005 AT 6992005
(43) Veröffentlichungstag der Anmeldung: 02.07.2008
(73) Patentinhaber: PLANSEE SE, 6600 Reutte (AT)
(72) Erfinder: ABENTHUNG, Peter, 6600 Reutte (AT); HUBER, Karl, 6600 Reutte (AT); LACKNER, Harald, 6600 Reutte (AT); LEICHTFRIED, Gerhard, 6600 Reutte (AT); POLCIK, Peter, 6600 Reutte (AT); WERATSCHNIG, Christian, 6600 Ruette (AT)
(86) Internationale Anmeldenummer: PCT/AT2006/000406
(87) Internationale Veröffentlichungsnummer: WO 2007/041730

(56) Entgegenhaltungen:
- EP-A1- 0 500 031
- EP-A1- 0 735 152
- WO-A-2006/026621
- AT-U1- 7 491
- DE-C1- 19 822 570
- JP-A- 2000 045 066
- US-A1- 2005 189 401

## Beschreibung

Die Erfindung betrifft ein Verfahren zur Herstellung eines Rohrtargets, das ein Rohr aus Molybdän oder einer Molybdänlegierung mit einem Sauerstoffgehalt kleiner 50 µg/g, einer Dichte größer 99% der theoretischen Dichte und einer mittleren Korngröße quer zur axialen Richtung kleiner 100 µm sowie ein Stützrohr aus einem nicht magnetischen Werkstoff umfasst.

Unter Target versteht man das zu sputternde Material einer Kathodenzerstäubungsanlage. Rotierende Rohrtargets sind bekannt und beispielsweise in der US 4,422,916 und der US 4,356,073 beschrieben. Dabei dreht sich beim Sputtern das Rohrtarget um ein im Rohr befindliches Magnetron. Rohrtargets werden überwiegend für die Herstellung großflächiger Beschichtungen verwendet. Durch die Rotation des Rohrtargets wird ein gleichmäßiger Abtrag des Sputtermaterials erzielt. Rohrtargets weisen daher eine hohe Ausnutzungsrate des Targetmaterials und eine lange Targetstandzeit auf, was insbesondere bei teuren Schichtmaterialien, wie dies bei Molybdän der Fall ist, von Bedeutung ist. So liegt die Ausnutzungsrate für planare Targets bei ca. 15 bis 40 % und für Rohrtargets bei 75 bis 90 %.

Die im Innenraum des Rohrtargets realisierte Targetkühlung ist durch den günstigeren Wärmeübergang im Rohr wesentlich wirksamer als bei planaren Targets, was eine höhere Beschichtungsrate ermöglicht. Um sicherzustellen, dass auch bei hoher Targetausnutzung kein Kühlwasser austritt, weiters um die mechanische Belastbarkeit zu erhöhen und die Fixierung in der Sputteranlage zu erleichtern, wird das Rohrtarget üblicherweise mit einem Stützrohr verbunden. Das Stützrohr muss dabei aus einem nicht magnetischen Werkstoff sein, um nicht in Wechselwirkung mit dem Magnetfeld, das den Abtragbereich bestimmt, zu treten.

Wie erwähnt ist der Einsatz von Rohrtargets dann vorteilhaft, wenn großflächige Substrate beschichtet werden. Im Falle von Molybdän als Targetwerkstoff ist dies beispielsweise bei der LCD-TFT Herstellung und der Glasbeschichtung der Fall.

Für die Herstellung von Rohrtargets sind viele Herstellverfahren beschrieben. Viele dieser Verfahren gehen dabei über eine Flüssigphasenroute, wie beispielsweise Strang- und Schleuderguss. So ist Letzteres in der DE 199 53 470 beschrieben. Auf Grund des hohen Schmelzpunkts von Molybdän und der daraus resultierenden Problematik eines geeigneten Formenwerkstoffs, lassen sich diese Herstellwege bei Molybdän und seinen Legierungen nicht realisieren.

Rohrtargets können auch durch Wickeln eines dicken Bandes um einen Kern und Verschweißen der Kontaktbereiche hergestellt werden. Die Schweißnaht weist jedoch ein deutlich gröberes Gefüge und Poren auf, was zu einem ungleichmäßigen Abtrag und als Folge zu unterschiedlichen Schichtstärken führt. Zudem ist der Schweißbereich bei Molybdän äußerst spröde und damit rissgefährdet.

Ein weiteres Rohrtarget ist aus der US 4,356,073 bekannt. Die Herstellung erfolgt dabei, indem das Sputtermaterial durch Plasmaspritzen auf einem Trägerrohr abgeschieden wird. Auch unter Verwendung der Vakuumplasma-Spritztechnik lassen sich jedoch keine vollständig dichten Rohrtargets mit ausreichend niedrigem Gasgehalt herstellen. Auch eine elektrochemische Abscheidung, wie dies für Cr und Sn angewandt wird, ist für Molybdän und seine Legierungen nicht geeignet.

In der EP 0 500 031 ist die Herstellung eines Rohrtargets durch heißisostatisches Pressen beschrieben. Dabei wird ein Trägerrohr in einer Kanne positioniert, sodass zwischen Trägerrohr und Matrize ein Zwischenraum entsteht, in dem Pulver des Targetmaterials eingefüllt wird. Nach Verschließen der Kanne wird diese einem heißisostatischen Verdichtungsvorgang unterzogen. Die Pulver-Einsatzmenge bezogen auf das Gewicht des fertigen Rohrtargets ist dabei ungünstig hoch.

Die US 6,878,250 und die US 6,946,039 beschreiben den Einsatz von ECAP (equal channel angular pressing) für die Herstellung von Sputtertargets. Bei Molybdänlegierungen mit vergleichsweise hohem k_{f} Werten führt dies zu einem hohen Werkzeugverschleiß.

EP-A-0735152 offenbart das Herstellen eines Grünlings durch kaltisostatisches Pressen und anschließendes Sintern und Umformen des Grünlings durch Schmieden oder Walzen.

Aufgabe der Erfindung ist es daher, ein Verfahren zur Herstellung eines Rohrtargets bereitzustellen, das zum einen kostengünstig ist und zum anderen ein Produkt liefert, das im Sputterprozess gleichmäßig abgetragen wird, zu keiner örtlich erhöhten Sputterrate neigt und zu keiner Verunreinigung des Substrates bzw. der abgeschiedenen Schicht führt.

Die Aufgabe wird durch die unabhängigen Ansprüche gelöst.

Um eine ausreichende Kornfeinheit, Sinterfähigkeit und damit Dichte zu erzielen, wird ein Metallpulver mit einer Teilchengröße nach Fisher von 0,5 bis 10 µm eingesetzt. Für die Herstellung von Rein-Mo Rohrtargets wird dabei vorteilhafterweise Mo Pulver mit einer metallischen Reinheit von größer 99,9 Gew.% eingesetzt. Wird ein Rohrtarget aus einer Mo-Legierung hergestellt, werden entweder Pulvermischungen oder vorlegierte Pulver eingesetzt, wobei jedoch die Teilchengröße ebenfalls im Bereich 0,5 bis 10 µm liegt. Das Pulver wird in eine flexible Matrize gefüllt, in der bereits ein Kern positioniert ist. Der Kern bestimmt den Innendurchmesser der herzustellenden Rohrluppe unter Berücksichtung der Verdichtung beim Pressvorgang und des Sinterschwundes. Als Werkstoff für den Kern eignen sich übliche Werkzeugstähle. Nach der Befüllung der flexiblen Matrize mit dem Metallpulver und flüssigkeitsdichtem Verschließen der flexiblen Matrize wird diese in einem Druckbehälter einer kaltisostatischen Presse positioniert. Die Verdichtung erfolgt bei Drücken von 100 bis 500 MPa. Danach wird der Grünling aus der flexiblen Matrize entnommen und der Kern entfernt. In weiterer Folge wird der Grünling bei einer Temperatur im Bereich 1600°C bis 2500°C in reduzierender Atmosphäre oder Vakuum gesintert. Unter 1600°C wird keine ausreichende Verdichtung erzielt. Über 2500°C setzt unerwünschte Kornvergröberung ein. Die zu wählende Sintertemperatur hängt von der Teilchengröße des Pulvers ab. Grünlinge, hergestellt aus einem Pulver mit einer Teilchengröße von 0,5 µm nach Fisher, können bereits bei einer Sintertemperatur von 1600 °C auf eine Dichte größer 95 % der theoretischen Dichte gesintert werden, während für Grünlinge, die aus einem Pulver mit einer Teilchengröße von 10 µm nach Fisher hergestellt werden, eine Sintertemperatur von in etwa 2500 °C erforderlich ist. Reicht die Formgenauigkeit des Pressprozesses nicht aus, was in der Regel der Fall ist, wird der Sinterling mechanisch bearbeitet. Der Außendurchmesser des Sinterlings wird dabei durch den Innendurchmesser des Containers der Strangpresse bestimmt. Um ein problemloses Positionieren des Strangpressrohlings im Container der Strangpresse zu ermöglichen, ist der Außendurchmesser des Sinterlings dabei etwas kleiner als der Innendurchmesser des Containers. Der Innendurchmesser wiederum wird durch den Dorndurchmesser bestimmt.

Um den Auspressverlust an Molybdän beim Strangpressen zu verringern, ist es vorteilhaft, an einem Ende der Molybdän-Rohrluppe ein Endstück aus Stahl mechanisch zu befestigen. Dieses mechanische Befestigen kann dabei beispielhaft durch eine Schrauben- oder Bolzenverbindung erfolgen. Der Außendurchmesser und der Innendurchmessers des Rohrluppenendstückes aus Stahl entsprechen dabei dem Außendurchmesser bzw. dem Innendurchmesser der Molybdän-Rohrluppe.

Zum Strangpressen wird die Rohrluppe auf eine Temperatur T, mit DBTT < T < (Tₛ -800°C) erhitzt. Unter DBTT ist dabei die Spröd-Duktil-Übergangstemperatur zu verstehen. Bei tieferen Temperaturen kommt es verstärkt zu Rissbildung. Das obere Temperaturlimit ergibt sich aus der Schmelztemperatur (Tₛ) der Molybdänlegierung minus 800 °C. Dies gewährleistet, dass während des Strangpressvorgangs keine unerwünschte Kornvergröberung stattfindet.

Das Anwärmen kann dabei in einem konventionellen gas- oder elektrisch beheizten Ofen (z.B. Drehherdofen) erfolgen, wobei zu berücksichtigen ist, dass die Gasführung so zu wählen ist, dass der Lambda-Wert neutral bzw. negativ ist. Um höhere Strangpresstemperaturen zu realisieren, kann ein induktives Nachwärmen erfolgen. Nach dem Anwärmvorgang wird die Rohrluppe in einer Glaspulvermischung gewälzt. Danach wird die Rohrluppe im Container der Strangpresse positioniert und über einen Dorn durch eine Matrize auf den jeweiligen Außen- bzw. Innendurchmesser gepresst.

Es ist vorteilhaft, wenn das stranggepresste Rohr einer erholenden oder rekristallisierenden Glühung in reduzierender Atmosphäre oder Vakuum bei einer Temperatur T von 700°C < T < 1600°C unterzogen wird. Wird das untere Temperaturlimit unterschritten, ist der Spannungsabbau zu gering. Bei einer Temperatur größer 1600°C tritt Kornvergröberung auf. Das stranggepresste Rohr wird mechanisch auf der Rohraußenseite, den Stirnflächen und vorteilhafterweise an der Rohrinnenseite bearbeitet.

Das so hergestellte Molybdän-Rohr wird mit einem Stützrohr aus einem nicht magnetischen Werkstoff verbunden. Der Außendurchmesser des Stützrohrs entspricht in etwa dem Innendurchmesser des Molybdän-Rohrs. Weiters reicht das Stützrohr über die jeweiligen Enden des Molybdän-Rohrs hinaus. Als besonders geeignete Werkstoffe für das Stützrohr sind Kupferlegierungen, austenitische Stähle, Titan bzw. Titanlegierungen zu erwähnen.

Als verbindungstechnische Verfahren sind sowohl solche, die zu einer stoff- als auch solche, die zu einer formschlüssigen Verbindung führen, geeignet. Bedingung ist jedoch, dass die Kontaktfläche zwischen Molybdän-Rohr und Stützrohr zumindest 30% der theoretisch möglichen Fläche beträgt. Ist die Fläche kleiner, wird die Wärmeabfuhr zu stark behindert. Zu berücksichtigen ist auch der niedrige thermische Ausdehnungskoeffizient von Molybdän. Es ist daher die Fügetemperatur so tief wie möglich zu wählen. Erfolgt beispielsweise das Verbinden zwischen Molybdän-Rohr und Stützrohr durch einen Schmiedeprozess, indem das Stützrohr im Molybdän-Rohr positioniert und über einen Dorn geschmiedet wird, sind möglichst tiefe Umformtemperaturen von ca. 500°C bis 800 °C zu wählen. Weiters ist es vorteilhaft, wenn der Werkstoff des Stützrohres eine niedrige Streckgrenze aufweist, damit entstehende Spannungen durch plastisches Fließen abgebaut werden können.

In einem weiteren erfindungsgemäßen Verfahren wird die Molybdän-Rohrluppe mit einem Rohling des Stützrohres Co-stranggepresst. Die Herstellung des Molybdänrohres erfolgt dabei wieder ausgehend von einem Metallpulver mit einer mittleren Teilchengröße nach Fisher von 0,5 -10 µm. Die Rohrluppe wird wiederum durch kaltisostatisches Pressen des Metallpulvers in einer flexiblen Matrize unter Verwendung eines Kernes und Sintern im Bereich von 1600 °C bis 2500 °C hergestellt.

Nach dem Sintern wird die Rohrluppe mechanisch bearbeitet. Im Innern der Rohrluppe wird ein Stützrohrrohling aus einem austenitischen Stahl positioniert. An einem oder beiden Endstücken der Rohrluppe wird ein Rohrendstück aus Stahl durch eine mechanische Verbindung (z.B. Schrauben- oder Bolzenverbindung) angefügt. Das Rohrendstück hat dabei in etwa den Innen- und Außendurchmesser der Rohrluppe. Die Stärke des Rohrendstücks liegt vorzugsweise im Bereich von 10 bis 100 mm. Am Rohrendstück wird wiederum der Stützrohrrohling befestigt. Dieses Befestigen erfolgt vorzugsweise durch eine Schweißverbindung.

Der Außendurchmesser des Stützrohrrohlings kann in etwa dem Innendurchmesser der Molybdän-Rohrluppe entsprechen oder auch so gewählt werden, dass zwischen der Molybdän-Rohrluppe und dem Stützrohrrohling ein definierter Spalt entsteht. In diesen definierten Spalt wird ein Stahlpulver bevorzugt aus austenitischem Stahl gefüllt. Der so hergestellte Verbundrohkörper wird auf eine Umformtemperatur von 900 °C bis 1350 °C erhitzt. Es lassen sich so nur Rohrtargets aus Molybdänlegierungen herstellen, die bei dieser Temperatur entsprechend verformbar sind. Eine höhere Strangpresstemperatur kann auf Grund des Stahles nicht gewählt werden.

Der so hergestellte Verbundrohrrohling wird über einen Dorn stranggepresst (Co-Strangpressen), wodurch ein Verbundrohr hergestellt wird. Optional kann in weiterer Folge eine Glühung durchgeführt werden, wobei die Glühtemperatur bevorzugt bei 800 °C bis 1300 °C liegt.

Durch Anwendung eines Spalts, mit dazwischen liegender Stahlpulverschüttung wird die Anbindung zwischen Stützrohr und Molybdänrohr beim Co-Strangpressen verbessert. Eine Spaltbreite von 3 mm bis 20 mm erweist sich dabei als vorteilhaft.

Durch die Verwendung von Glaspulver als Schmiermittel wird sowohl beim Strangpressen als auch Co-Strangpressen eine ausgezeichnete Oberfläche des Rohrtargets erreicht, wodurch die mechanische Bearbeitung auf ein Minimum reduziert werden kann. Weiters wird damit gewährleistet, dass das Rohrtarget porenfrei bzw. auch frei von Korngrenzenrissen ist. Als vorteilhafter Umformgrad beim Strangpressprozess hat sich der Bereich von 40 bis 80 % herausgestellt. Der Umformgrad wird dabei folgendermaßen bestimmt: ((Ausgangsquerschnitt vor dem Strangpressen minus Querschnitt nach dem Strangpressen) / Ausgangsquerschnitt) x 100.

Nach dem Strangpress- / Co-Strangpressprozess kann es vorteilhaft sein, dass das stranggepresste Rohr gerichtet wird. Dies kann über einen Dorn durch einen Schmiedeprozess erfolgen.

Weiters kann durch einen nachgelagerten Schmiedeprozess auch die Wandstärke über der Länge des Molybdän-Rohrs oder Verbundrohrs variiert werden. Vorteilhafterweise kann dabei die Wandstärke im Bereich der Rohrenden dicker ausgeführt werden. Der Bereich der Rohrenden ist auch im Einsatz der Bereich des größten Abtrages.

Durch eine entsprechende mechanische Bearbeitung werden die Oberflächengüte und die Maßtoleranzen eingestellt.

Durch das erfindungsgemäße Verfahren wird gewährleistet, dass der Sauerstoffgehalt in der Molybdänlegierung < 50 µg/g, bevorzugt kleiner 20 µg/g, die Dichte größer 99 % der theoretischen Dichte, bevorzugt größer 99,8 % der theoretischen Dichte und die mittlere Korngröße quer zur axialen Richtung kleiner 100 µm, bevorzugt keiner 50 µm beträgt. Die mittlere Korngröße wird deshalb quer zur axialen Richtung bestimmt, da bei einem umgeformten, nicht rekristallisierten Gefüge die Körner in axialer Richtung gestreckt sind und damit eine exakte Bestimmung der Korngröße in axialer Richtung erschwert ist.

Mit beiden beschriebenen Verfahren ist es möglich Molybdänrohrtargets mit einer metallischen Reinheit von größer 99,99 Gew.% herzustellen. Unter metallischer Reinheit ist dabei die Reinheit des Molybdänrohrtargets ohne Gase (O, H, N) und C zu verstehen. Auch das für die Anwendung unkritische Wolfram ist in diesem Wert nicht berücksichtigt.

Für die Verwendung dieser erfindungsgemäßen Rohrtargets im Bereich der TFT-LCD Herstellung eignen sich in besonderer Weise auch Molybdänlegierungen, die 0,5 bis 30 Gew.% V, Nb, Ta, Cr und / oder W enthalten.

Im Folgenden ist die Erfindung durch ein Beispiel näher erläutert.

### Beispiel:

MoO₃ Pulver wurde in einem zweistufigen Reduktionsprozess bei 600 bzw. 1000 °C zu Mo-Metallpulver mit einer Korngröße von 3,9 µm reduziert. In einem einseitig geschlossenen Gummischlauch mit einem Durchmesser von 420 mm wurde ein Stahldorn mit einem Durchmesser von 141 mm in der Mitte positioniert. In den Zwischenraum zwischen Stahlkern und Gummiwandung wurde das Molybdänmetallpulver gefüllt.

Der Gummischlauch wurde in weiterer Folge an dessen offenen Ende mittels einer Gummikappe verschlossen. Der verschlossene Gummischlauch wurde in einer kaltisostatischen Presse positioniert, und bei einem Druck von 210 MPa verdichtet.

Der Grünling wies eine Dichte von 64 % der theoretischen Dichte auf. Der Außendurchmesser betrug in etwa 300 mm. Der so hergestellte Grünling wurde in einem Indirektsinterofen bei einer Temperatur von 1900 °C gesintert. Die Sinterdichte betrug 94,9 % der theoretischen Dichte.

Nach dem Sintervorgang wurde die Rohrrohluppe allseitig bearbeitet, wobei der Außendurchmesser 243 mm, der Innendurchmesser 123 mm und die Länge 1060 mm betrug. Das Strangpressen erfolgte auf einer 2500 t Indirektstrangpresse. Der Rohrluppenrohling wurde auf eine Temperatur von 1100 °C in einen gasbeheizten Drehherdofen erhitzt. Der Lambdawert wurde dabei so eingestellt, dass die Atmosphäre leicht reduzierend war, wodurch eine Oxidation des Molybdäns verhindert wurde. Nach dem Anwärmen im Drehherdofen wurde der Strangpressrohling induktiv auf eine Temperatur von 1250 °C erwärmt und in einer Schüttung aus Glaspulver gewälzt, so dass außenseitig allseitig Glaspulver anhaftete.

In weiterer Folge wurde über einen Dorn gepresst, wodurch ein stranggepresstes Rohr mit einer Länge von 2700 mm, einem Außendurchmesser von 170 mm und einem Innendurchmesser von 129 mm entstand.

Im stranggepressten Rohr wurde ein Stützrohr aus einem austenitischen Stahl mit einer Wandstärke von 6 mm positioniert. Dieser Zusammenbau wurde über einen Dorn auf einer Drei-Backenschmiedemaschine bei einer Temperatur von 500°C gerichtet und geringfügig verformt, wodurch auch ein Verbund zwischen dem Molybdänrohr und Stützrohr entstand.

## Patentansprüche

1. Verfahren zur Herstellung eines Rohrtargets, umfassend ein Rohr aus Molybdän oder einer Molybdänlegierung mit einem Sauerstoffgehalt kleiner 50 µg/g, einer Dichte größer 99% der theoretischen Dichte und einer mittleren Korngröße quer zur axialen Richtung kleiner 100 µm sowie ein Stützrohr aus einem nicht magnetischen Werkstoff,
**dadurch gekennzeichnet,**
**dass** dieses zumindest die folgenden Herstellschritte umfasst:
• Herstellen eines Metallpulvers aus Mo oder einer Mo-Legierung mit einer mittleren Teilchengröße nach Fisher von 0,5 bis 10 µm;
• Herstellen eines Grünlings in Form einer Rohrluppe durch kaltisostatisches Pressen des Metallpulvers in einer flexiblen Matrize unter Verwendung eines Kernes bei einem Druck p, mit 100 MPa < p < 500 MPa;
• Herstellen einer Rohrluppe durch Sintern des Grünlings bei einer Temperatur T, mit 1600 °C < T < 2500 °C in reduzierender Atmosphäre oder Vakuum;
• Herstellung eines Rohres durch Erwärmen der Rohrluppe auf Umformtemperatur T, mit DBTT < T < (Tₛ - 800°C) und Strangpressen über einen Dorn
• Fügen des Rohres mit dem Stützrohr
• Mechanische Bearbeitung

2. Verfahren nach Anspruch 1, **dadurch gekennzeichnet, dass** die gesinterte Rohrluppe mechanisch bearbeitet wird.

3. Verfahren nach Anspruch 2, **dadurch gekennzeichnet, dass** zumindest an einem Ende der Rohrluppe ein Rohrendstück aus Stahl befestigt wird, das in etwa den gleichen Außen- und Innendurchmesser wie die Rohrluppe aufweist.

4. Verfahren nach einem der Ansprüche 1 bis 3, **dadurch gekennzeichnet, dass** das stranggepresste Rohr in reduzierender Atmosphäre oder Vakuum bei einer Glühtemperatur T von 800°C < T < 1600°C geglüht wird.

5. Verfahren nach einem der Ansprüche 1 bis 4, **dadurch gekennzeichnet, dass** das Stützrohr aus einer Kupferlegierung, bevorzugt Cu-Cr-Zr, austenitischem Stahl, Titan oder einer Titanlegierung besteht.

6. Verfahren nach einem der Ansprüche 1 bis 5, **dadurch gekennzeichnet, dass** das Stützrohr durch einen Fügeprozess mit dem Rohr aus Molybdän oder einer Molybdänlegierung verbunden wird, der zu einer plastischen Verformung des Stützrohres führt.

7. Verfahren nach Anspruche 6, **dadurch gekennzeichnet, dass** das Stützrohr durch einen Umformprozess mit dem Rohr aus Molybdän oder einer Molybdänlegierung verbunden wird.

8. Verfahren zur Herstellung eines Rohrtargets, umfassend ein Rohr aus Molybdän oder einer Molybdänlegierung mit einem Sauerstoffgehalt kleiner 50 µg/g, einer Dichte größer 99% der theoretischen Dichte und einer mittleren Korngröße quer zur axialen Richtung kleiner 100 µm sowie ein Stützrohr aus einem nicht magnetischen Werkstoff,
**dadurch gekennzeichnet,**
**dass** dieses zumindest die folgenden Herstellschritte umfasst:
• Herstellen eines Metallpulvers aus Mo oder einer Mo-Legierung mit einer mittleren Teilchengröße nach Fisher von 0,5 bis 10 µm;
• Herstellen eines Grünlings in Form einer Rohrluppe durch kaltisostatisches Pressen des Metallpulvers in einer flexiblen Matrize unter Verwendung eines Kernes bei einem Druck p, mit 100 MPa < p < 500 MPa;
• Herstellen einer Rohrluppe durch Sintern des Grünlings bei einer Temperatur T, mit 1600 °C < T < 2500 °C in reduzierender Atmosphäre oder Vakuum;
• Bearbeiten der Rohrluppe und Anfügen zumindest eines Rohrendstückes aus Stahl, womit ein im Innern der Rohrluppe liegender Stützrohrrohling aus austenitischem Stahl fixiert wird;
• Herstellung eines Verbundrohres durch Erwärmen auf Umformtemperatur T, mit 900 < T < 1350°C und Co-Strangpressen über einen Dorn;
• Mechanische Bearbeitung

9. Verfahren nach Anspruch 8, **dadurch gekennzeichnet, dass** das Verbundrohr in reduzierender Atmosphäre oder Vakuum bei einer Glühtemperatur T von
800°C < T < 1300°C geglüht wird.

10. Verfahren nach einem der Ansprüche 8 oder 9, **dadurch gekennzeichnet, dass** zwischen der Rohrluppe und dem Stützrohrrohling ein Spalt von 0,2 bis 1 mm besteht.

11. Verfahren nach einem der Ansprüche 8 oder 9, **dadurch gekennzeichnet, dass** zwischen der Rohrluppe und dem Stützrohrrohling ein Spalt von 3 mm bis 20 mm besteht, der mit Stahlpulver befüllt wird.

12. Verfahren nach einem der Ansprüche 1 bis 11, **dadurch gekennzeichnet, dass** Glaspulver zur Schmierung beim Strangpressen verwendet wird.

13. Verfahren nach einem der Ansprüche 1 bis 12, **dadurch gekennzeichnet, dass** der Umformgrad beim Strangpressen 40 bis 80 % beträgt.

14. verfahren nach einem der Ansprüche 1 bis 13, **dadurch gekennzeichnet, dass** das stranggepresste Rohr oder Verbundrohr auf einem Dorn durch einen Schmiedeprozess gerichtet wird.

15. Verfahren nach einem der Ansprüche 1 bis 14, **dadurch gekennzeichnet, dass** das stranggepresste Rohr oder Verbundrohr auf einem Dorn durch einen Schmiedeprozess so verformt wird, dass die Wandstärke über die Rohrlänge unterschiedlich ist.

16. Verfahren nach Anspruch 15, **dadurch gekennzeichnet, dass** das stranggepresste Rohr oder Verbundrohr so verformt wird, dass zu den Rohrenden hin das Rohr eine größere Wandstärke aufweist.

17. Verfahren nach einem der Ansprüche 1 bis 16, **dadurch gekennzeichnet, dass** das Molybdän-Rohr aus Rein-Molybdän mit einer metallischen Reinheit exklusive Wolfram von größer 99,99 Gew.% besteht.

18. Verfahren nach einem der Ansprüche 1 bis 16, **dadurch gekennzeichnet, dass** das Molybdän-Rohr aus einer Molybdänlegierung besteht, die 0,5 bis 30 Gew.% V, Nb, Ta, Cr und / oder W enthält.

19. Verwendung des nach einem der-Ansprüche 1-18 hergestellten Rohrtarget für die Herstellung von LCD-TFT Flachbildschirmen.

20. Verwendung des nach einem der Ansprüche 1-18 hergestellten Rohrtarget für die Glasbeschichtung.

## Claims

1. Method for producing a tubular target, comprising a tube of molybdenum or a molybdenum alloy with an oxygen content of less than 50 µg/g, a density of greater than 99% of the theoretical density and an average grain size transversely to the axial direction of less than 100 µm as well as a supporting tube of a non-magnetic material, **characterized in that** this method comprises at least the following production steps:
• production of a metal powder from Mo or an Mo alloy with an average particle size according to Fisher of from 0.5 to 10 µm;
• production of a green compact in the form of a tube blank by cold-isostatic pressing of the metal powder in a flexible mould using a core at a pressure p, where 100 MPa < p < 500 MPa;
• production of a tube blank by sintering the green compact at a temperature T, where 1600°C < T < 2500°C, in a reducing atmosphere or a vacuum;
• production of a tube by heating the tube blank to forming temperature T, where DBTT < T < (Tₛ minus 800°C) and extrusion over a mandrel;
• joining of the tube to the supporting tube;
• machining.

2. Method according to Claim 1, **characterized in that** the sintered tube blank is machined.

3. Method according to Claim 2, **characterized in that** a steel tube end piece, which has approximately the same outside and inside diameter as the tube blank, is fastened at least to one end of the tube blank.

4. Method according to one of Claims 1 to 3, **characterized in that** the extruded tube is annealed in a reducing atmosphere or a vacuum at an annealing temperature T of 800°C < T < 1600°C.

5. Method according to one of Claims 1 to 4, **characterized in that** the supporting tube consists of a copper alloy, preferably Cu-Cr-Zr, austenitic steel, titanium or a titanium alloy.

6. Method according to one of Claims 1 to 5, **characterized in that** the supporting tube is connected by a joining process to the tube of molybdenum or molybdenum alloy, which leads to a plastic deformation of the supporting tube.

7. Method according to Claim 6, **characterized in that** the supporting tube is connected to the tube of molybdenum or a molybdenum alloy by a forming process.

8. Method for producing a tubular target, comprising a tube of molybdenum or a molybdenum alloy with an oxygen content of less than 50 µg/g, a density of greater than 99% of the theoretical density and an average grain size transversely to the axial direction of less than 100 µm as well as a supporting tube of a non-magnetic material, **characterized in that** this method comprises at least the following production steps:
• production of a metal powder from Mo or an Mo alloy with an average particle size according to Fisher of from 0.5 to 10 µm;
• production of a green compact in the form of a tube blank by cold-isostatic pressing of the metal powder in a flexible mould using a core at a pressure p, where 100 MPa < p < 500 mPa;
• production of a tube blank by sintering the green compact at a temperature T, where 1600°C < T < 2500°C, in a reducing atmosphere or a vacuum;
• working of the tube blank and joining at least one steel tube end piece, whereby a supporting tube of austenitic steel blank lying inside the tube blank is fixed;
• production of a composite tube by heating to forming temperature T, where 900 < T < 1350°C and co-extrusion over a mandrel;
• machining.

9. Method according to Claim 8, **characterized in that** the composite tube is annealed in a reducing atmosphere or a vacuum at an annealing temperature T of 800°C < T < 1300°C.

10. Method according to either of Claims 8 and 9, **characterized in that** a gap of 0.2 to 1 mm exists between the tube blank and the supporting tube blank.

11. Method according to either of Claims 8 and 9, **characterized in that** a gap of from 3 mm to 20 mm exists between the tube blank and the supporting tube blank and is filled with steel powder.

12. Method according to one of Claims 1 to 11, **characterized in that** glass powder is used for lubrication during the extrusion.

13. Method according to one of Claims 1 to 12, **characterized in that** the degree of forming during the extrusion is 40 to 80%.

14. Method according to one of Claims 1 to 13, **characterized in that** the extruded tube or composite tube is straightened on a mandrel by a forging process.

15. Method according to one of Claims 1 to 14, **characterized in that** the extruded tube or composite tube is deformed on a mandrel by a forging process in such a way that the wall thickness differs over the length of the tube.

16. Method according to Claim 15, **characterized in that** the extruded tube or composite tube is deformed in such a way that the tube has a greater wall thickness towards the ends of the tube.

17. Method according to one of Claims 1 to 16, **characterized in that** the molybdenum tube consists of pure molybdenum with an exclusively tungsten metallic purity of greater than 99.99% by weight.

18. Method according to one of Claims 1 to 16, **characterized in that** the molybdenum tube consists of a molybdenum alloy which contains 0.5 to 30% by weight of V, Nb, Ta, Cr and/or W.

19. Use of the tube target produced according to any one of Claims 1 to 18 for production of LCD-TFT flat screens.

20. Use of the tube target produced according to any one of Claims 1 to 18 for glass coating.

## Revendications

1. Procédé de fabrication d'une cible tubulaire comportant un tube en molybdène ou en un alliage de molybdène dont la teneur en oxygène est inférieure à 50 µg/g, la densité supérieure à 99% de la densité théorique et la grosseur de grain moyenne inférieure à 100 µm perpendiculairement à l'axe, ladite cible comportant, en outre, un tube de support en un matériau non magnétique et ledit procédé de fabrication étant **caractérisé en ce qu'**il comprend, au minimum, les opérations suivantes :
- Elaboration d'une poudre de métal en Mo ou en un alliage de Mo dont la grosseur de grain moyenne selon Fisher est comprise entre 0,5 et 10 µm ;
- Fabrication d'un comprimé cru tubulaire par compression isostatique à froid de la poudre de métal dans une matrice flexible, avec utilisation d'un noyau, à une pression p comprise entre 100 et 500 Mpa;
- Fabrication d'une ébauche tubulaire par frittage du comprimé cru à une température T comprise entre 1.600°C et 2.500°C, sous atmosphère réductrice ou sous vide;
- Fabrication d'un tube par échauffement de l'ébauche tubulaire à une température de formage T comprise entre DBTT et (Tₛ - 800°C) et filage sur aiguille;
- Assemblage du tube au tube de support
- Usinage

2. Procédé selon la revendication 1, **caractérisé en ce que** l'ébauche tubulaire frittée est usinée.

3. Procédé selon la revendication 2, **caractérisé par** un embout de tube en acier fixé à l'une au moins des extrémités de l'ébauche tubulaire et présentant approximativement le même diamètre externe et interne que ladite ébauche.

4. Procédé selon l'une quelconque des revendications 1 à 3, **caractérisé en ce que** le tube filé est recuit sous atmosphère réductrice ou sous vide à une température T comprise entre 800 et 1.600°C.

5. Procédé selon l'une quelconque des revendications 1 à 4, **caractérisé en ce que** le tube de support est réalisé en un alliage de cuivre, de préférence de Cu-Cr-Zr, en acier austénitique, en titane ou en un alliage de titane.

6. Procédé selon l'une quelconque des revendications 1 à 5, **caractérisé en ce que** le tube de support est joint au tube en molybdène ou en un alliage de molybdène par un mode d'assemblage qui conduit à une déformation plastique du tube de support.

7. Procédé selon la revendication 6, **caractérisé en ce que** le tube de support est joint au tube en molybdène ou en un alliage de molybdène par un mode de formage.

8. Procédé de fabrication d'une cible tubulaire comportant un tube en molybdène ou en un alliage de molybdène dont la teneur en oxygène est inférieure à 50 µg/g, la densité supérieure à 99% de la densité théorique et la grosseur de grain moyenne inférieure à 100 µm perpendiculairement à l'axe, ladite cible comportant, en outre, un tube de support en un matériau non magnétique et ledit procédé étant **caractérisé en ce qu'**il comprend, au minimum, les opérations suivantes :
- Elaboration d'une poudre de métal en Mo ou en un alliage de Mo dont la grosseur de grain moyenne selon Fisher est comprise entre 0,5 et 10 µm ;
- Fabrication d'un comprimé cru tubulaire par compression isostatique à froid de la poudre de métal dans une matrice flexible, avec utilisation d'un noyau, à une pression p comprise entre 100 et 500 Mpa;
- Fabrication d'une ébauche tubulaire par frittage du comprimé cru à une température T comprise entre 1.600°C et 2.500°C, sous atmosphère réductrice ou sous vide;
- Usinage de l'ébauche tubulaire et adjonction d'au moins un embout de tube en acier à l'aide duquel on fixe une ébauche de support tubulaire en acier austénitique disposée à l'intérieur de l'ébauche de tube;
- Fabrication d'un tube composite par échauffement à une température de formage T comprise entre 900°C et 1.350°C et filage conjoint sur aiguille;
- Usinage.

9. Procédé selon la revendication 8, **caractérisé en ce que** le tube composite est recuit sous atmosphère réductrice ou sous vide à une température T comprise entre 800 et 1.300°C.

10. Procédé selon la revendication 8 ou 9, **caractérisé par** la présence, entre l'ébauche de tube et l'ébauche de support tubulaire, d'un espace libre compris entre 0,2 et 1 mm.

11. Procédé selon la revendication 8 ou 9, **caractérisé par** la présence, entre l'ébauche de tube et l'ébauche de support tubulaire, d'un espace libre compris entre 3 et 20 mm que l'on remplit de poudre d'acier.

12. Procédé selon l'une quelconque des revendications 1 à 1 1 , **caractérisé par** l'emploi de verre pulvérisé comme lubrifiant de filage.

13. Procédé selon l'une quelconque des revendications 1 à 12, **caractérisé par** un taux de déformation au filage compris entre 40 et 80%.

14. Procédé selon l'une quelconque des revendications 1 à 13, **caractérisé en ce que** l'on dresse le tube filé ou le tube composite filé en le forgeant sur un mandrin.

15. Procédé selon l'une quelconque des revendications 1 à 14, **caractérisé en ce que** l'on déforme le tube filé ou le tube composite filé en le forgeant sur un mandrin de telle sorte que l'épaisseur de la paroi du tube soit variable sur la longueur dudit tube.

16. Procédé selon la revendication 15, **caractérisé en ce que** l'on déforme le tube filé ou le tube composite filé de telle sorte que l'épaisseur de la paroi du tube soit plus grande vers les extrémités dudit tube.

17. Procédé selon l'une quelconque des revendications 1 à 16, **caractérisé en ce que** le tube en molybdène est composé de molybdène pur dont la pureté métallique est supérieure à 99,99% en poids, le tungstène non compris.

18. Procédé selon l'une quelconque des revendications 1 à 16, **caractérisé en ce que** le tube en molybdène est composé d'un alliage de molybdène dont la teneur en V, Nb, Ta, Cr et/ou W est comprise entre 0,5 et 30% en poids.

19. Mise en oeuvre de la cible tubulaire réalisée selon l'une quelconque des revendications 1 à 18, dans la fabrication d'écrans plats LCD/TFT.

20. Mise en oeuvre de la cible tubulaire réalisée selon l'une quelconque des revendications 1 à 18, dans le revêtement du verre.
